# EUROPEAN PATENT SPECIFICATION

(11) **EP 0 299 775 B1**
(45) Date of publication and mention of the grant of the patent: **28.04.1993**
(21) Application number: 88306472.7
(22) Date of filing: 14.07.1988
(51) Int. Cl.: H01L 21/60, H01L 23/04, H01L 23/48

(54) **Method of assembling a tab bonded semiconductor chip package**
Verfahren zum Zussamenbau einer Halbleiterchip-Packung mit automatischer Bandmontage
Procédé pour mettre dans un boîtier une puce semi-conductrice à montage automatique sur bande

(30) Priority: 16.07.1987 US 73991
(43) Date of publication of application: 18.01.1989
(73) Proprietor: DIGITAL EQUIPMENT CORPORATION, Maynard, MA 01754 (US)
(72) Inventor: Doe, Ralph W., Auburn Massachusetts 01501 (US); Hansen, Steven P., Amherst New Hampshire 03031 (US); Brown, Kenneth M., North Andover Massachusetts 01845 (US)
(74) Representative: Goodman, Christopher

(56) References cited:
- GB-A- 1 185 857
- US-A- 4 096 348
- "VLSI" Technology", ed. by S.M. Sze, McGraw Hill, 1st Edition 1983
- PATENT ABSTRACTS OF JAPAN, vol. 10, no. 376 (E-464)[2433], 13th December 1986; & JP-A-61 168 247
- Electronics, Dec. 1981, pp. 66-75
- Jerry Lyman: "Packaging VLSI," Electronics, Dec. 1981, pages 66-75

## Description

### FIELD OF THE INVENTION

This invention relates generally to the field of packaging for integrated circuit chips, and more particularly to a package compatible with chips attached to tape automated bonding tape.

### BACKGROUND OF THE INVENTION

Packaging is one of the final steps in the process of manufacturing integrated electrical semiconducting circuit components or chips. In packaging, a fabricated semiconductor chip is mounted in a protective housing. After packaging the assembled component is subjected to final testing and then connected to an electronic circuit.

Currently, many semiconductor chips are contained in plastic packages. These packages are provided with reinforced metal leads for electrically connecting the chip to the printed circuit board which contains the circuit in which the chip is to be included. Within the package, one end of each lead is connected to a specific bonding point on the chip, usually by an intermediate lead; the other end of the lead, which extends outside of the package, is attached to a connection on the printed circuit board.

Recently, advances in semiconductor manufacturing technology have made the fabrication of Very Large Scale Integration (VLSI) chips possible. VLSI chips comprise a large number of individual circuit components that are fabricated together on a single, very small chip. VLSI chips are able to perform a large number of electrical functions, and perform them more rapidly, than was previously possible.

To date, it has been difficult to provide suitable packaging for VLSI chips. One reason for this is because each VLSI chip requires a large number of connections to external circuit elements. Many VLSI chips have 100 to over 300 bonding points, each of which must be individually connected to a lead for connection to external circuit elements. This is a difficult task to perform because of the space in which these connections must be made is very small and because the chips are relatively fragile devices and the connections to them must be made with a considerable amount of care.

Tape Automated Bonding (TAB) is one of the few practical methods that have been developed in order to provide electrical connections to VLSI chips. In TAB, a chip is bonded to a section of TAB tape that has a number of individual leads that are plated on a film of insulating material. The film, which serves as a support for the leads, has a center opening which the chip is mounted over. The TAB leads are arranged so they extend outward from a center opening of the film; and project beyond its outer perimeter. Thus, each TAB lead has an inner lead portion that extends into the center opening of the film and an outer lead portion that extends beyond the outer perimeter of the film. A chip is positioned over the film center lead opening and is bonded to the lead inner lead portions at its bonding points; the outer lead portions of the leads are then attached to the appropriate conductive elements, such as contact pads on a printed wire board. Since the film can support an almost limitless number of leads, TAB has been an especially effective means to provide electrical connections to the bonding points of VLSI chips. Moreover, TAB is a cost-effective means of providing electrical connection to the chips.

Another reason that, to date, it has been difficult to provide a package suitable for a VLSI chip is the need to include a means to efficiently dissipate the heat generated by the chip. A chip generates heat as a consequence of its consuming power in order to perform the function it is designed for. Heat dissipation is an important consideration in the design of a chip package because most chips should be operated at temperatures below 80°C. If a chip becomes too hot, the semiconductor junctions, which form the basic electrical components within the chip, have a tendency to break down and the chip may malfunction.

Heat dissipation characteristics are an especially important consideration in packages designed to house VLSI chips. This is because VLSI chips consume more power than their predecessors, and as a result, generate more heat. Therefore, a package in which a VLSI chip is housed should include some means to efficiently extract the heat, or otherwise cool the chip therein in order to insure it consistently functions properly.

There have been a number of chip packages developed which provide some path, such as a cooling fluid or a heat spreader, through which heat can be diffused away from the chips therein. However, many of these packages are designed so that only reinforced contact pins can be used to provide the needed electrical connections between the external circuit and the chips within the packages. In order to mount the package with contact pins on a circuit board, complementary plated-through holes are needed on the circuit board. The plated-through holes extend through the circuit board in which they are formed, and as a result, the conductors on the circuit board must be designed around them. This may be a difficult task if the circuit board contains a large number of conductors, as is required by most modern electronic circuits.

One type of semiconductor package, designed for individual chips, that has good heat dissipation characteristics is the cerquad package. A cerquad package is formed of ceramic with a base that includes a raised shelf around its perimeter that defines a seating space where the chip is housed. A lead frame, formed of spaced apart reinforced metal leads, is embedded between the shelf, above where the chip is seated, and a ceramic frame disposed over the base. Each metal lead has an interior portion which projects into the interior of the package and an exterior portion which extends out from the package. A lid is secured to the frame over the seating space so as to complete the package and protect the chip therein.

A chip is assembled inside a cerquad package by first securing the chip in the seating space by a process known as die attachment. The bonding points on the chip are then electrically connected to the appropriate leads by wires that are individually attached therebetween. The lid is sealed over the seating space to complete the assembly process. In the assembled cerquad package, the metal leads function as conductive paths between the chip and the associated components of the electronic circuit the chip is connected to.

Cerquad packages have good thermal conductivity characteristics, that is heat readily transfers through them. A cooling fin assembly can readily be attached to the outer surface of the base of a cerquad package, so the heat transferred thereto from the chip can be rapidly diffused into the external environment. Cerquad packages can be readily manufactured to contain a single chip. Also, cerquad packages have leads that enable them to be easily surface mounted to the circuits which the chips they house are designed for. This eliminates the need to provide plated-through holes on the circuit board for electrically connecting the chip to the circuit, and the attendant need to design the circuit board conductors around the plated-through holes. Moreover, cerquad packages are very economical to manufacture. Thus, it is often desirable to package a stand-alone chip with significant heat generating characteristics in a cerquad package.

To date, however, it has been difficult to house a VLSI chip inside a cerquad package. This is in part due to the problems associated with connecting the bonding points of a VLSI chip to the package leads that connect the chip to the other elements of the circuit to which it is attached. Wire bonding of the individual bonding points to the individual leads is a time consuming and expensive process that is prone to error because of the large number of leads and small spaces involved.

It has also been very difficult to house a chip with TAB leads inside a cerquad package. In part this is because the cerquad lead frame inevitably warps when it is embedded in the package. As a result, the lead frame leads are uneven and the outer lead portions of the TAB leads cannot be attached thereto by automated processes, such as one referred to as "gang bonding" which require the attachment be preformed on an even surface. The TAB lead outer lead portion must thus be individually attached to the lead frame leads. This is a costly process that is prone to error.

Moreover, glass is normally used to seal the frame to the base of a cerquad package so as to embed the lead frame therebetween. In order to apply the glass to the package, the glass's temperature must be raised to its flow point, which typically is 400°C. Problems arise because TAB film starts to delaminate at approximately 300°C. As a result of the delamination, the TAB leads warp, cross, and become loosened from their bonding points on the chip and from the cerquad package leads so as to render the assembled package useless. Thus, it has been very difficult to attach a VLSI chip, or any other TAB bonded chip, in a cerquad package.

Reference is hereby made to two prior art documents:
US Patent No. 4,096,348 discloses a semiconductor integrated circuit device having a ceramic base with beam leads protruding along its perimeter, and an interconnection substrate with a plurality of inter connection leads. A chip is bonded to the inner lead portions of the interconnection leads, and the outer lead portions of the interconnection leads, are bonded to the beam leads of the base.

GB Patent No. 1,185,857 discloses an integrated circuit assembly having a semiconductor chip or die with contact pads lying in a common plane adjacent the die's outer perimeter. The assembly includes a lead frame carrying spaced, mutually insulated leads. The leads have contact areas arranged in an interconnect pattern exclusively adjacent the outer perimeter of an inner area and lying in a common plane. Connecting elements, formed of metallic film on a sheet-like insulating member or tab, provide electrical connections between the contact areas of the leads and the contact pads of the die. According to that patent, in forming the assembly, the die is attached to the inner portions of the connecting elements by ultrasonic bonding. After the die has been attached, the outer portions of the connecting elements are attached to the contact areas of the leads, also by ultrasonic bonding.

According to the present invention there is provided a method of assembling a semiconductor package containing an electronic component therein, comprising the steps of:
a) inner lead bonding a section of tape automated bonding tape to the electronic component, said tape automated bonding tape having a plurality of conductive leads thereon, each tape automated bonding lead having an inner lead portion and an outer lead portion, wherein in said inner lead bonding said inner lead portions are attached to bonding points on the electronic component;
b) outer lead bonding the tape automated bonding tape to a lead frame, said lead frame having a plurality of spaced apart reinforced metal leads, wherein in said outer lead bonding said tape automated bonding lead outer lead portions are attached to said lead frame leads; and characterised in that said method includes the step of
c) substantially simultaneously die attaching said electronic component and tape automated bonding tape in the semiconductor package and embedding said lead frame in said semiconductor package, wherein said semiconductor package includes a base defining a seating space for disposing the electronic component and tape automated bonding tape therein and a lid assembly disposed over said base and seating space so that said lead frame is embedded therebetween, wherein in said die attaching the electronic component is secured in said base seating space and in said lead frame embedding said lead frame is disposed on said base and said lid assembly is secured to said base so said lead frame is embedded therebetween.

### BRIEF DESCRIPTION OF THE DRAWINGS

Figure 1 is a top exploded view of a cerquad package of this invention attached to a portion of a lead frame strip after the package assembly process and prior to separating from the lead frame strip.

Figure 2a is a cross-section view of a chip inner lead bonded to a section of tape automated bonding tape.

Figure 2b is a cross-section view of the assembly of Fig. 2a outer lead bonded to a lead frame.

Figure 2c is a cross-section view of the assembly of Fig. 2b lead embedded and die attached into a cerquad package.

Figure 2d is a cross-section view of the assembly of Fig. 2c receiving a lid.

Figure 2e is a cross section view of the assembled cerquad package of Fig. 2d after a heat sink has been attached thereto and the metal leads have been shaped.

### DETAILED DESCRIPTION OF THE INVENTION

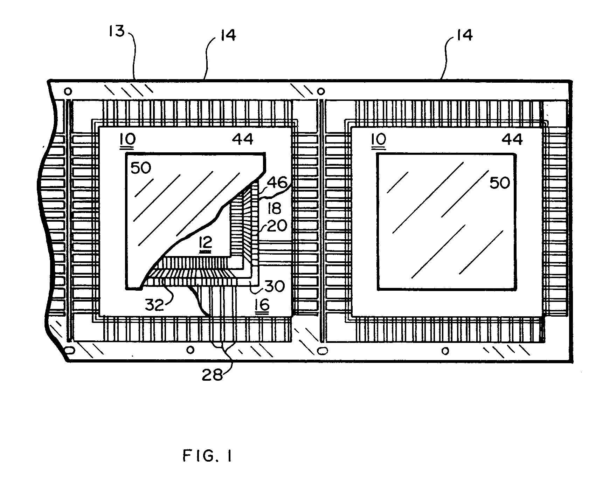

Figure 1 illustrates a number of cerquad packages 10, constructed in accordance with this invention each of which contains a single semiconductor chip 12. The cerquad packages 10 are attached to a lead frame strip 13 that comprises a number of individual lead frames 14 linearly attached together so the cerquad packages 10 may be assembled automatically by equipment that sequentially advances the lead frame 13 that carries the partially assembled packages 10 to different assembly stations. After the cerquad packages 10 are assembled, they are severed from the lead frame strip 13 for final testing and installation into the circuit they are designed for.

The individual cerquad packages 10 each contain a base 16 formed of ceramic. Extending around the outer perimeter of the base 16 is a raised outer shelf 18 that defines a seating space 20 within the center of the base. The chip 12, such as a VLSI chip, is die attached into the seating space 20.

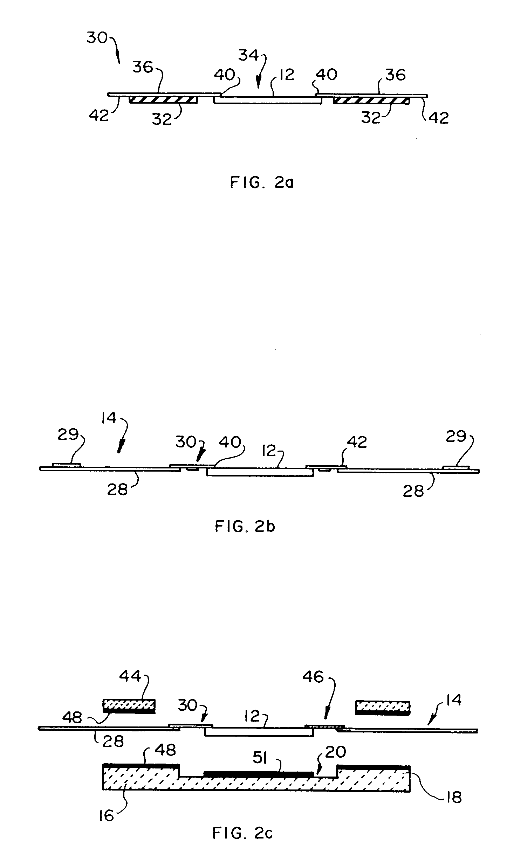

Each lead frame 14 is positioned on the base outer shelf 18 of the cerquad package 10 it is part of and comprises a number of separate reinforced metal leads 28. Each lead frame lead 28 extends from the edge of the outer shelf 18 adjacent to the seating space 20 to beyond the perimeter of the cerquad package 10 so it can be surface mounted to a contact pad on the printed circuit board the pack is intended for. A ring 29 (Figure 2b) of Kapton material ("Kapton" being a registered trademark), or other suitable dielectric, may be secured to the lead frame leads 28 to prevent them from becoming out of alignment.

A section of TAB tape 30, best seen by reference to Figure 2a, is attached to the chip 12 and lead frame leads. The TAB tape 30 comprises a section of film 32 of Kapton, or other suitable dielectric, with a center opening 34 to accommodate the chip 12 and a number of flexible conductive leads 36 plated thereon. Each TAB lead 36 has an inner lead portion 40 that projects into the center opening 34 which is attached to a bonding point on the chip 12, and an outer lead portion 42 which is bonded to a lead frame lead 28.

A ceramic frame 44 is fastened to the base outer shelf 18 so that the lead frame 14 is secured therebetween. The frame 44 defines an opening 46 over the chip 12, the seating space 20, the TAB tape 30, and the portion of the lead frame metal leads 28 where the TAB leads 36 are attached thereto. Epoxy 48 (Figure 2c), or other suitable adhesive, that can be cured at temperatures below that which the TAB tape 30 delamintates, and when secured forms a liquid-tight seal, is used to secure the frame 44 and base 16 together. A lid 50 is sealed over frame opening 46 to complete the protective shell the cerquad package 10 provides around the chip 12.

Referring to Figures 2a-e, the assembly of the cerquad package 10 is shown in detail. Initially, the chip 12 is bonded to the TAB lead inner lead portions 40 of the TAB tape 30, (Figure 2a) in accordance with known TAB bonding practices. The TAB lead outer lead portions 42 are then attached to the lead frame leads 28 (Figure 2b) . The TAB lead outer lead portions 42 and lead frame leads 28 are attached together by a process known as "gang bonding" wherein by an automated process all the outer lead portion 42 to lead frame lead 28 bonding occurs simultaneously. This assembly occurs while the individual lead frames are attached to the lead frame strip 13 (Figure 1).

The lead frame 14-TAB tape 30-chip 12 subassembly is then advanced to a station (Figure 2c) where it is attached to the base 16 and frame 44. At this station the chip 12 is secured in the seating space 20 by the process of die attachment wherein a suitable adhesive 51 known in the art is used to secure the chip 12 therein. Concurrently with the die attachment, the lead frame 14 is embedded in the package 10 by positioning the frame 44 over the base outer shelf 18 and applying the epoxy 48 to fasten the two together, securing the lead frame 14 therebetween.

The epoxy 48 used to fasten the frame 44 to the outer shelf 18 is applied to the opposed surfaces of the ceramic base outer shelf 18 and the frame 44 prior to the lead embedding process. The epoxy 48 is applied so it is partially cured, in a "B-stage," so it can later be cured, or reflowed around the lead frame leads 28, during the lead embedding process. During the lead embedding process, the epoxy is cured at a temperature below 200°C. A suitable epoxy for this purpose is Epoxy No. NCO-125RF manufactured by the Kyocera Company of Kyoto, Japan, which can be cured, will reflow at, a temperature below 200°C, and after curing forms a liquid-tight seal.

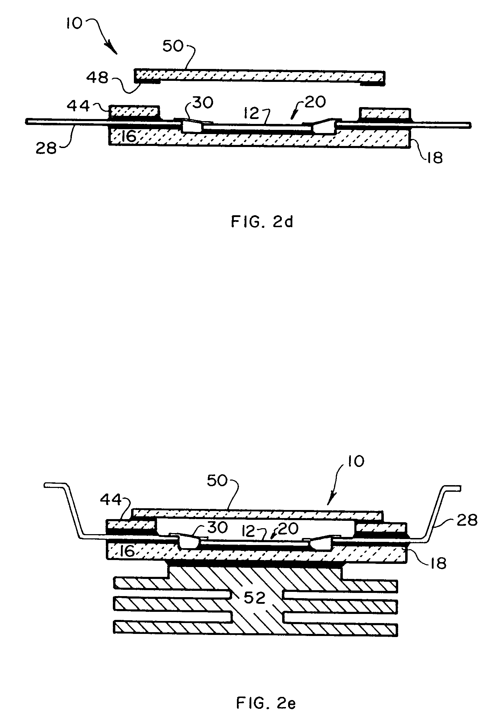

After the die attachment and lead frame embedding processes are completed, the partially assembled package 10 is advanced to a curing station where air is vented away from the package. The venting of air away from the package evacuates any volatiles chat may be emitted from the epoxy 48 when it is applied and cured. After the epoxy 48 adjacent to the lead frame 14 and chip 12 has at least partially cured, the lid 50 may be attached to complete assembly of the cerquad package 10 using the epoxy 48 as an adhesive (Figure 2d). At this stage, it is only necessary to pre-apply the epoxy 48 to one of the surfaces that are attached together; typically the epoxy 48 is only pre-applied to the lid 50.

After the cerquad package 10 is assembled, it is severed from the lead frame strip 13. The exposed portions of the lead frame leads 28 may then be shaped so they will contact the surface contact pads that they are to be connected to (Figure 2e). A heat sink 52 may be attached to cerquad packages 10, usually on a portion of the exposed face of the base 16 adjacent to the chip 12. Thus when the assembled package is mounted on a circuit board, the lid is positioned adjacent the board.

The assembled cerquad package 10 protects the chip 12 therein from external forces. Moreover, the ceramic material of this package readily conducts heat therethrough; the large amounts of heat a chip may generate will thus be readily transferred away therefrom to the external surface of the package. In other words, the heat generated by the chip 12 will be efficiently conducted away therefrom through the package 10, minimizing the possibility the chip 12 will malfunction due to becoming overheated. Also, the package can be readily designed to accommodate a single chip 12 and not occupy an excessive amount of space.

The chip 12 housed within the cerquad package is electrically connected to the lead frame leads 28 by a section of TAB tape 30. The use of the TAB tape 30 to make the electrical connections is possible in part because the epoxy 48 cures at a relatively low temperature. At the temperature the epoxy 48 is cured, the TAB tape 30 will not de laminate so as to cause the TAB leads 36 to become loose and break their connections to the chip bonding points and the lead frame leads 28, severing the electrical connections therebetween. Also, the lead frame leads 28 are planar prior to the attachment of the chip 12 and TAB tape 30 sub-assembly thereto. This makes it possible to perform such attachment by gang bonding or other automated processes that require attachment to be performed on a level surface.

The cerquad package 10 is well suited to accommodate a VLSI chip which typically has a large number of bonding points, is usually provided with TAB bonded electrical connections, and that generates significant amounts of heat which must be efficiently dissipated away therefrom.

After the chip 12 is die attached to this cerquad package, the air adjacent the package is vented away prior to securing the lid 50 to the frame 44. The venting evacuates volatiles that the epoxy 48 or die attachment adhesive may emit while they cure. This minimizes the concentration of volatiles adjacent the chip 12 that may corrode it, causing its semiconductor junctions to break down and the chip 12 to malfunction.

This cerquad package 10 can be economically assembled. In part, this is because the electrical connections required by the package, the inner lead bonding of the TAB leads 36 to the chip bonding points and outer lead bonding of the TAB leads 36 to the lead frame leads 28, can both be performed economically and rapidly by automated equipment that does not make a significant number of assembly errors.

Another reason the cerquad package 10 is economical to assemble is that the components of the package are assembled simultaneously with mounting the chip inside the package. It is more cost-effective for the assembler to assemble the package at this time than to purchase a pre-assembled cerquad package from another source.

The foregoing description has been limited to a specific embodiment of the invention. It will be apparent, however, that variations and modifications may be made to the invention, with the attainment of some or all of the advantages of this invention. For instance, it would be possible to construct a semiconductor package of this invention designed to accommodate two or more semiconductor chips. A multi-chip package could be constructed to house the chips in one large seating space, or be provided with separate seating spaces for each of the chips therein. Also, the package of this invention may be constructed out of material other than ceramic that has the appropriate thermal conductivity characteristics. Adhesives other than epoxy may be used to lead embed the lead frame and die attach the chips.

## Claims

1. A method of assembling a semiconductor package (10) containing an electronic component (12) therein, comprising the steps of:
a) inner lead bonding a section of tape automated bonding tape (30) to the electronic component, said tape automated bonding tape having a plurality of conductive leads (36) thereon, each tape automated bonding lead having an inner lead portion (40) and an outer lead portion (42), wherein in said inner lead bonding said inner lead portions are attached to bonding points on the electronic component (12);
b) outer lead bonding the tape automated bonding tape to a lead frame (14), said lead frame having a plurality of spaced apart reinforced metal leads (28), wherein in said outer lead bonding said tape automated bonding lead outer lead portions (42) are attached to said lead frame leads (28); and characterised in that said method includes the step of
c) substantially simultaneously die attaching said electronic component (12) and tape automated bonding tape (30) in the semiconductor package (10) and embedding said lead frame (14) in said semiconductor package, wherein said semiconductor package includes a base (16) defining a seating space (20) for disposing the electronic component and tape automated bonding tape therein and a lid assembly (50) disposed over said base and seating space so that said lead frame (14) is embedded therebetween, wherein in said die attaching the electronic component is secured in said base seating space (20) and in said lead frame embedding said lead frame (14) is disposed on said base (16) and said lid assembly (50) is secured to said base so said lead frame is embedded therebetween.

2. The method of assembling a semiconductor package according to claim 1 further including the step of curing an adhesive (48) applied to said base (16) to fasten said lid assembly (50) to said base so as to embed said lead frame (14) therebetween.

3. The method of assembling a semiconductor package according to claim 2 further including the step of curing the adhesive (48) at a temperature below 200°C.

4. The method of assembling a semiconductor package according to claim 1 further including the step of:
disposing a frame (44) defining a frame opening between said base and seating space (16,20), and said lid assembly (50).

5. The method of assembling a semiconductor package according to claim 4 further including the step of curing an adhesive (48) applied to said base (16) to secure said frame (44) to said base so as to embed said lead frame (14) therebetween, and to secure said lid (50) to said frame.

6. The method of assembling a semiconductor package according to claim 5 further including the step of curing said adhesive (48) at a temperature below 200°C.

7. The method of assembling a semiconductor package according to claim 2 or claim 5 further including the step of curing said adhesive (48) at a temperature substantially below that at which said tape automated bonding tape (30) delaminates.

8. The method of assembling a semiconductor package according to claim 4 further including the step of venting the air adjacent the semiconductor package after the die attachment and lead embedding and prior to securing the lid thereto.

## Patentansprüche

1. Verfahren zum Zusammenbauen eines Halbleitergehäuses (10), das eine elektronische Komponente (12) enthält und das die folgenden Schritte aufweist:
a) Innenanschluß-Bondieren eines Abschnitts eines bandautomatisierten Bondierbandes (30) mit der elektronischen Komponente, wobei das bandautomatisierte Bondierband eine Vielzahl von leitenden Anschlüssen (36) aufweist, wobei jeder bandautomatisierte Bondieranschluß einen Innenanschlußabschnitt (40) und einen Außenanschlußabschnitt (42) hat, wobei beim Innenanschlußbondieren die Innenanschlußabschnitte auf Bondierpunkten auf der elektrischen Komponente (12) angebracht werden;
b) Außenanschluß-Bondieren des bandautomatisierten Bondierbandes mit einem Anschlußarahmen (14), wobei der Anschlußrahmen eine Vielzahl zueinander beabstandeter, verstärkter Metallanschlüsse (28) hat und wobei beim Außenanschluß-Bondieren die bandautomatisierten Anschluß-Aussenanschlußabschnitte (42) an den Anschlußrahmen-Anschlüssen (28) angeschlossen werden, dadurch gekennzeichnet, daß das Verfahren den folgenden Schritt aufweist
c) im wesentlichen gleichzeitiges Chip-Anschließen der elektronischen Komponente (12) und des bandautomatisierten Bondierbandes (30) in dem Halbleitergehäuse (10) und Unterbringen des Anschlußrahmens (14) in dem Halbleitergehäuse, wobei das Halbleitergehäuse eine Basis (16) enthält, die einen Aufnahmeraum (20) zum Aufnehmen der elektronischen Komponente und des bandautomatisierten Bondierbandes im Aufnahmeraum definiert, und eine Deckelanordnung (50) enthält, die über der Basis und dem Aufnahmeraum angeordnet ist, so daß der Anschlußrahmen (14) dazwischen untergebracht ist, wobei beim Chip-Anschließen die elektronische Komponente in dem Aufnahmeraum (20) der Basis gesichert ist und wobei beim Unterbringen des Anschlußrahmens der Anschlußrahmen (14) auf der Basis (16) angeordnet wird und die Deckelanordnung (50) an der Basis gesichert ist, so daß der Anschlußrahmen dazwischen untergebracht ist.

2. Verfahren zum Zusammenbauen eines Halbleitergehäuses gemäß Anspruch 1, das weiterhin den Schritt des Aushärtens eines Klebers (48) enthält, der der Basis (16) zugefügt wird, um die Deckelanordnung (50) an der Basis zu befestigen, damit der Anschlußrahmen (14) dazwischen untergebracht ist.

3. Verfahren zum Zusammenbauen eines Halbleitergehäuses gemäß Anspruch 2, das weiterhin den Schritt des Aushärtens des Klebers (48) bei einer Temperatur unterhalb von 200°C aufweist.

4. Verfahren zum Zusammenbauen eines Halbleitergehäuses gemäß Anspruch 1, das weiterhin den Schritt aufweist:
Anordnen eines Rahmens (44), der eine Rahmenöffnung zwischen der Basis und dem Aufnahmeraum (16, 20) und der Deckelanordnung (50) definiert.

5. Verfahren zum Zusammenbauen eines Halbleitergehäuses gemäß Anspruch 4, das weiterhin den Schritt des Aushärtens des Klebers (48) enthält, der der Basis (16) zugefügt wird, um den Rahmen (44) an der Basis zu befestigen, damit der Anschlußrahmen (14) dazwischen untergebracht ist und damit der Deckel (50) am Rahmen gesichert ist.

6. Verfahren zum Zusammenbauen eines Halbleitergehäuses gemäß Anspruch 5, das weiterhin den Schritt des Aushärtens des Klebers (48) bei einer Temperatur unterhalb 200°C aufweist.

7. Verfahren zum Zusammenbauen eines Halbleitergehäuses gemäß Anspruch 2 oder Anspruch 5, das weiterhin den Schritt des Aushärtens des Klebers (48) bei einer Temperatur enthält, die im wesentlichen unterhalb derjenigen Temperatur ist, bei der sich das bandautomatisierte Bondierband (30) aufspaltet.

8. Verfahren zum Zusammenbauen eines Halbleitergehäuses gemäß Anspruch 4, das weiterhin den Schritt des Entlüftens der Luft, die benachbart zu dem Halbleitergehäuse ist, nach dem Chip-Anschließen und dem Unterbringen des Anschlusses und vor dem Sichern des Deckels enthält.

## Revendications

1. Procédé pour assembler un boîtier de semi-conducteur (10) qui renferme un composant électronique (12), comportant les étapes de :
a) soudage de connexions intérieures d'une section d'une bande de soudage automatique sur bande (30) avec le composant électronique, ladite bande de soudage automatique sur bande présentant sur elle plusieurs connexions conductrices (36) dont chacune possède une partie de connexion intérieure (40) et une partie de connexion extérieure (42), étant précisé que, pendant ledit soudage des connexions intérieures, lesdites parties de connexions intérieures sont fixées à des points de soudure prévus sur le composant électronique (12);
b) soudage de connexions extérieures de la bande de soudage automatique sur bande avec une grille de connexions (14), ladite grille de connexions comportant plusieurs connexions en métal renforcé (28) espacées les unes des autres, étant précisé que, pendant ledit soudage des connexions extérieures, ledites parties de connexions extérieures (42) de la bande de soudage automatique sur bande sont fixées auxdites connexions de grille de connexions (28); et caractérisé en ce que ledit procédé comprend l'étape qui consiste à :
c) fixer sensiblement simultanément, pour former une puce, ledit composant électronique (12) et ladite bande de soudage automatique sur bande (30) dans le boîtier de semi-conducteur (10) et à encastrer ladite grille de connexions (14) dans ledit boîtier de semi-conducteur, ledit boîtier de semi-conducteur comportant une base (16) qui définit un espace de logement (20) pour disposer le composant électronique et la bande de soudage automatique sur bande dans celui-ci, et un ensemble formant couvercle (50) disposé par dessus ladite base et ledit espace de logement de façon que ladite grille de connexions (14) soit encastrée entre ceux-ci, étant précisé que, pendant ladite fixation de la puce, le composant électronique est assujetti dans ledit espace de logement (20) de la base, tandis que, pendant ledit encastrement de la grille de connexions, ladite grille de connexions (14) est disposée sur ladite base (16) et ledit ensemble formant couvercle (50) est assujetti à ladite base de sorte que ladite grille de connexions est encastrée entre ceux-ci.

2. Procédé pour assembler un boîtier de semi-conducteur, selon la revendication 1, comportant également l'étape de durcissement d'un adhésif (48) appliqué à ladite base (16) pour fixer ledit ensemble formant couvercle (50) à ladite base, afin d'encastrer ladite grille de connexions (14) entre ceux-ci.

3. Procédé pour assembler un boîtier de semi-conducteur, selon la revendication 2, comportant aussi l'étape de durcissement de l'adhésif (48) à une température inférieure à 200°C.

4. Procédé pour assembler un boîtier de semi-conducteur, selon la revendication 1, comportant, en outre, l'étape qui consiste à :
disposer un cadre (44) définissant une ouverture de cadre entre ladite base (16) et ledit espace de logement (20), et ledit ensemble formant couvercle (50).

5. Procédé pour assembler un boîtier de semi-conducteur, selon la revendication 4, comportant, de surcroît, l'étape de durcissement d'un adhésif (48) appliqué à ladite base (16) pour assujettir ledit cadre (44) à ladite base, afin d'encastrer ladite grille de connexions (14) entre ceux-ci, et pour assujettir ledit couvercle (50) audit cadre.

6. Procédé pour assembler un boîtier de semi-conducteur, selon la revendication 5, comportant également l'étape de durcissement dudit adhésif (48) à une température inférieure à 200°C.

7. Procédé pour assembler un boîtier de semi-conducteur, selon la revendication 2 ou la revendication 5, comportant aussi l'étape de durcissement dudit adhésif (48) à une température sensiblement inférieure a celle à laquelle ladite bande de soudage automatique sur bande (30) se décolle.

8. Procédé pour assembler un boîtier de semi-conducteur, selon la revendication 4, comportant, en outre, l'étape qui consiste à évacuer l'air à proximité du boîtier de semi-conducteur après la fixation de la puce et l'encastrement de la grille de connexions et avant l'assujettissement du couvercle à ceux-ci.
